# FASCICULE DE BREVET EUROPEEN

(11) **EP 0 406 056 B1**
(45) Date de publication et mention de la délivrance du brevet: **08.09.1993**
(21) Numéro de dépôt: 90401686.2
(22) Date de dépôt: 15.06.1990
(51) Int. Cl.: H05K 5/06, H05K 5/00

(54) **Boitier rainure pour composants hybrides**
Gehäuse für hybride Bauelemente, das eine Rille enthält
Case for hybrid components containing a groove

(30) Priorité: 23.06.1989 FR 8908407
(43) Date de publication de la demande: 02.01.1991
(73) Titulaire: EGIDE S.A., F-78190 Trappes (FR)
(72) Inventeur: Maquaire, Jean-Pierre, F-78430 Louveciennes (FR); Dody, Jean-Noel, F-92500 Rueil-Malmaison (FR)
(74) Mandataire: Tilloy, Anne-Marie

(56) Documents cités:
- DE-A- 1 956 880
- DE-U- 1 990 387
- FR-A- 2 336 852
- US-A- 4 506 108

## Description

La présente invention concerne un boîtier pour composants électroniques, notamment hybrides. Elle s'applique plus particulièrement aux boîtiers qui sont soumis à des tests en herméticité postérieurement à la fermeture du boîtier par un couvercle, voir par ex. DE-A-19 56 880.

Dans des applications nécessitant des boîtiers particulièrement fiables sur le plan de leur herméticité, par exemple en aérospatial, les boîtiers sont testés sur une durée de 2 à 3 mois afin de vérifier la tenue de leur herméticité dans le temps.

Généralement, on teste un boîtier lors de sa fermeture en introduisant dans celui-ci, juste avant la pose du couvercle, un mélange d'azote et d'hélium dosé, et en détectant immédiatement les fuites d'hélium sortant du boîtier. Un tel test ne peut s'effectuer qu'instantanément lors de la fermeture du boîtier, en effet en cas de fuite dans celui-ci, l'hélium disparaît quasi-immédiatement.

Afin de soumettre un boîtier fermé à un test en herméticité, on utilise généralement une méthode dite de ressuage qui consiste à placer le boîtier sous une pression de l'ordre de 2 à 4 bars afin d'injecter l'hélium dans le boîtier à travers les fuites qui peuvent exister. On détecte ensuite la présence d'hélium ressortant du boîtier ce qui implique que celui-ci présente des fuites ; dans le cas où le boîtier est hermétique, l'hélium n'aura pas pu pénétrer dans celui-ci lors de l'injection et donc on ne détectera pas d'hélium en ressortant.

Le problème de ces tests par la méthode du ressuage, est que la mise sous pression du boîtier a pour conséquence de provoquer des fissures dans des perles de verre servant au passage des connecteurs reliant l'intérieur du boîtier avec l'extérieur. Un tel boîtier fissuré ne présentant pas de fuites lors des tests en herméticité suivant la méthode de ressuage, n'est pas pour autant fiable car il se trouve affaibli et présente de ce fait un gros risque de défaut d'herméticité à court terme.

Ces fissures appelées également criques dans les perles de verre sont dues notamment au cintrage auquel se trouvent soumises des parois latérales du boîtier en raison des forces de pression appliquées sur le dessus du couvercle lors de la mise sous pression. Le fait que la fermeture du boîtier par le couvercle s'effectue par soudure et que la soudure du couvercle sur le dessus de parois soit concentrée vers l'extérieur du boîtier, accroît encore le phénomène de cintrage.

On constate ainsi généralement une plus grande quantité de perles criquées au milieu des parois latérales que vers les bords de celles-ci où elles rejoignent une paroi latérale partant dans une autre direction. Ceci s'explique par la plus grande rigidité des parois latérales à proximité des coins du boîtier.

Une première solution déjà proposée consiste à accroître la rigidité des parois latérales dans leur portion comprise entre les perles de verre et le couvercle en élargissant les parois de manière à limiter les déformations des parois latérales lors de la mise sous pression du boîtier.

Cette solution est quasiment inefficace car les perles de verre ou de céramique sont trop sensibles et les espaces de matière subsistant longitudinalement entre les perles dans les parois latérales sont généralement trop réduits pour que les perles ne soient soumises à aucun effort.

La présente invention vise à éliminer les inconvénients décrits ci-dessus en réalisant un boîtier pour composants électroniques et notamment hybrides auquel puissent être appliqués des tests en hermiticité selon la méthode dite du ressuage, sans que la mise en oeuvre même de ces tests ne mette en cause l'hermiticité du boîtier.

Selon sa caractéristique principale, la présente invention concerne un boîtier pour composants électroniques notamment hybrides comportant un fond, une enceinte constituée de parois latérales et un couvercle propre à fermer hermétiquement le boîtier en prenant appui sur une extrémité supérieure des parois latérales, caractérisé en ce qu'au moins une paroi latérale comportant des orifices de passage de connecteurs propres à mettre en liaison l'intérieur du boîtier avec l'extérieur comporte, dans une portion supérieure comprise entre lesdits orifices et ladite extrémité supérieure, au moins une rainure longitudinale.

A l'instar des solutions déjà proposées qui consistent à renforcer la rigidité de la paroi latérale en cherchant à supprimer l'effet de cintrage, la présente invention propose de favoriser cet effet de cintrage en affaiblissant les parois latérales en en réduisant partiellement l'épaisseur.

On pourrait penser que l'affaiblissement des parois latérales a pour conséquence d'accroître encore les risques de fissures lors de la mise sous pression du boîtier, mais la solution proposée par l'invention permet avantageusement de contrôler l'endroit où se produit la déformation de la paroi. En effet, le fait de fragiliser la paroi latérale par enlèvement de matière, en ménageant dans celle-ci une rainure longitudinale dans sa partie supérieure, a pour effet que lors de la mise sous pression du boîtier, la paroi latérale ne se déforme que dans sa partie supérieure sans qu'aucune contrainte ne s'exerce sur les perles de verre insérées dans les orifices de passage de conducteurs, la rainure jouant en quelque sorte un rôle de charnière.

Selon un premier mode de réalisation du boîtier selon l'invention, ladite rainure est avantageusement ouverte vers l'intérieur du boîtier.

Selon un deuxième mode de réalisation particulièrement avantageux du boîtier selon l'invention, la rainure est ouverte vers l'extérieur du boîtier, ceci afin de faciliter l'usinage des parois latérales. Il est en effet plus aisé de ménager une rainure sur la face externe de la paroi que sur la surface interne.

Selon d'autres caractéristiques avantageuses de l'invention :
- chacune des parois latérales du boîtier comportant des orifices de passage de connecteurs comporte au moins une rainure longitudinale.
- une rainure longitudinale est ménagée sur tout le pourtour de l'enceinte constituée des parois latérales.

Selon une caractéristique particulièrement avantageuse de l'invention, ladite rainure est dimensionnée en profondeur et en hauteur en fonction des déformations que doit absorber ladite portion supérieure en raison des pressions sur ledit couvercle.

On peut ainsi adapter la taille de la rainure ménagée dans les parois latérales du boîtier en fonction de la taille de ce dernier et des efforts de pression que devront absorber les parois. En effet plus la taille du boîtier est grande, c'est-à-dire plus l'écart entre les parois latérales est important, plus lors de la mise sous pression du boîtier, la résultante des forces de pression rapportées sur les parois latérales est importante.

Selon d'autres caractéristiques du boîtier selon l'invention :
- ladite paroi latérale comporte deux rainures longitudinales parallèles dans sa portion supérieure ;
- et selon une variante, lesdites parois latérales comportent de part et d'autre desdits orifices de passage, au moins une rainure longitudinale.

En effet, le fond du boîtier étant en général brasé sur ladite enceinte, alors que le couvercle y est soudé, les parois latérales sont plus sensibles aux déformations dans leur portion supérieure. Mais on peut également prévoir et surtout dans le cas où le fond serait rapporté sur l'enceinte par soudure, de ménager une rainure longitudinale à la fois dans la portion supérieure et dans la portion inférieure des parois latérales, c'est-à-dire de part et d'autre des orifices de passage.

On a ainsi réalisé un boîtier pour composants électroniques, notamment hybrides pour lequel les tests en herméticité, même par la méthode dite du ressuage, peuvent être effectués sans avoir pour conséquence de nuire à la fiabilité du boîtier et sans pour autant nuire de manière sensible aux qualités mécaniques du boîtier.

On décrira maintenant plus en détail une forme de réalisation particulière de l'invention qui en fera mieux comprendre les caractéristiques essentielles et les avantages, étant entendu toutefois que cette forme de réalisation est choisie à titre d'exemple et qu'elle n'est nullement limitative. Sa description est illustrée par les dessins annexés, dans lesquels :
- la figure 1 représente une vue en perspective d'un boîtier selon l'invention ;
- la figure 2 représente en coupe partielle un boîtier selon la présente invention ;
- la figure 3 représente schématiquement la déformation que subissent les parois latérales dans un boîtier tel que celui représenté à la figure 2 ;
- et la figure 4 représente une variante du boîtier selon l'invention ;

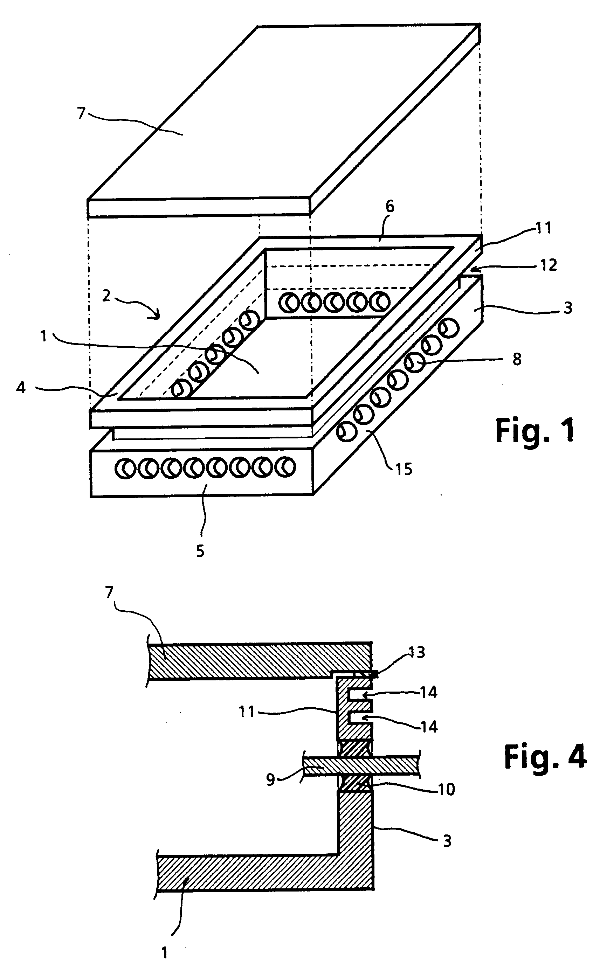

Le boîtier représenté à la figure 1 comporte un fond 1 et une enceinte 2 constituée de parois latérales respectivement 3, 4, 5 et 6. Un tel boîtier peut être constitué d'un alliage de fer/nickel/cobalt connu sous la dénomination commerciale Kovar. Et la cuvette constituée du fond et des parois latérales peut être obtenue par emboutissage d'une plaque de tôle en Kovar.

Cette cuvette est destinée à être fermée, une fois que les composants électroniques y ont été implantés, par un couvercle 7 lui aussi généralement en Kovar (marque déposée), le couvercle étant soudé sur les tranches libres des parois latérales.

Bien entendu l'invention s'applique pour des boîtiers constitués en d'autres matériaux comme par exemple des boîtiers en céramique, en plastique ou en alliage métallique

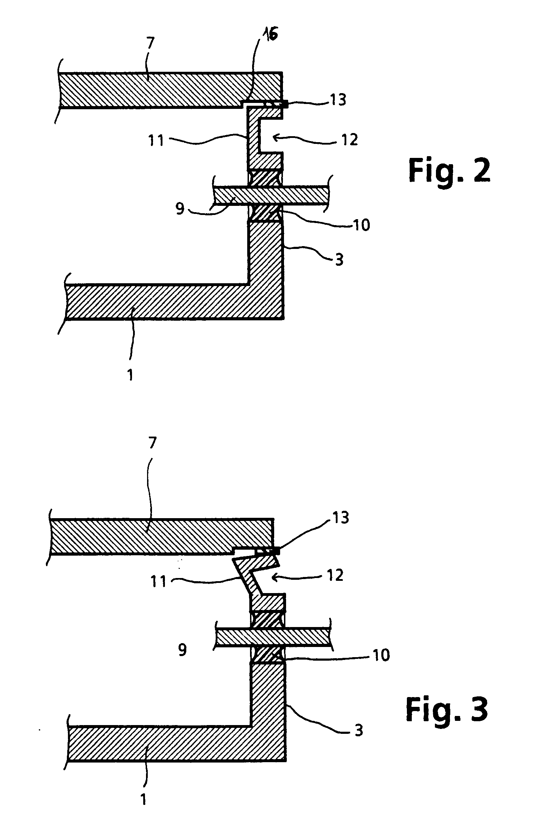

Afin de permettre le passage de connecteurs entre l'intérieur et l'extérieur du boîtier, les parois latérales sont généralement pourvues d'orifices 8 dans lesquels est apposé un conducteur généralement en ferro-nickel, entouré par une perle de verre ou de céramique 10 (figure 2).

Les parois latérales 3, 4, 5 et 6 comportent dans une portion supérieure 11, une rainure longitudinale 12 fragilisant les parois dans cette portion. Le tracé de cette rainure 12 décrit le pourtour extérieur de l'enceinte 2 afin de répartir de manière régulière l'affaiblissement sur toutes les parois.

La figure 2, qui représente en coupe partielle un boîtier selon l'invention, comporte les mêmes éléments que ceux représentés à la figure 1. Ceux-ci sont désignés par les mêmes références. Le boîtier est représenté en position fermée, le couvercle 7 étant soudé sur la tranche des parois latérales, la soudure y est désignée par la référence 13. Généralement, le couvercle 7 est conformé de manière à présenter un décrochement périphérique 16 propre à coopérer avec la tranche des parois latérales.

La figure 3 montre de manière schématique et exagérée, les déformations subies par la parai latérale lorsque le boîtier est mis sous pression lors de tests en herméticité par la méthode dite de ressuage. On constate que la portion supérieure de la paroi latérale 3 se déforme en procurant en quelque sorte un effet de charnière, de sorte que seule cette portion supérieure 11 supporte les contraintes de la mise sous pression et que les perles de verre 10 n'aient aucune contrainte à supporter et ne risquent pas ainsi de se fissurer.

La figure 4 représente une variante de réalisation du boîtier selon l'invention, dans lequel la portion supérieure 11 de la paroi latérale 3 comporte deux rainures longitudinales parallèles 14 afin d'accroître l'effet d'élasticité.

La profondeur et la hauteur de la rainure 12 des parois latérales peuvent être déterminées, par exemple par un calcul de moments de force, en évaluant les contraintes auxquelles sont susceptibles d'être soumises les parois latérales lors de la mise sous pression du boîtier par l'effet des forces de pression appliquées sur le couvercle.

Au cas où la cuvette du boîtier est réalisée en deux pièces, c'est-à-dire que le fond 1 est rapporté sur l'enceinte 2, on peut prévoir de réaliser dans la portion inférieure 15 des parois 11, une rainure ayant le même but que la rainure 12 vis-à-vis de l'élasticité des portions supérieures.

Naturellement, l'invention n'est en rien limitée par les particularités qui ont été spécifiées dans ce qui précède ou par les détails du mode de réalisation particulier choisi pour illustrer l'invention. Toutes sortes de variantes peuvent être apportées à la réalisation particulière qui a été décrite à titre d'exemple et à ses éléments constitutifs sans sortir pour autant du cadre de l'invention. Cette dernière englobe ainsi tous les moyens constituant des équivalents techniques des moyens décrits ainsi que leurs combinaisons.

## Revendications

1. Boîtier pour composants électroniques notamment hybrides comportant un fond (1), une enceinte (2) constituée de parois latérales (3,4,5,6) et un couvercle (7) propre à fermer hermétiquement le boîtier en prenant appui sur une extrémité supérieure des parois latérales, caractérisé en ce qu'au moins une paroi latérale comportant des orifices de passage (8) de connecteurs (9) propres à mettre en liaison l'intérieur du boîtier avec l'extérieur comporte, dans une portion supérieure (11) comprise entre lesdits orifices (8) et ladite extrémité supérieure, au moins une rainure longitudinale (12).

2. Boîtier selon la revendication 1, caractérisé en ce que ladite rainure (12) est ouverte vers l'extérieur du boîtier.

3. Boîtier selon la revendication 1, caractérisé en ce que ladite rainure (12) est ouverte vers l'intérieur du boîtier.

4. Boîtier selon l'une quelconque des revendications 1 à 3, caractérisé en ce que chacune de ses parois latérales (3,4,5,6) comportant des orifices de passage (8) de connecteurs comporte au moins une rainure longitudinale (12).

5. Boîtier selon l'une quelconque des revendications 1 à 4, caractérisé en ce que ladite rainure (12) est dimensionnée en profondeur et en hauteur en fonction des déformations que doit absorber ladite portion supérieure (11) en raison des pressions sur ledit couvercle.

6. Boîtier selon l'une quelconque des revendications 1 à 5, caractérisé en ce que ladite paroi latérale comporte deux rainures longitudinales parallèles (14).

7. Boîtier selon l'une quelconque des revendications 1 à 6, caractérisé en ce que lesdites parois latérales comportent de part et d'autre desdits orifices de passage (8) au moins une rainure longitudinale.

8. Boîtier selon l'une des revendications 1 à 7, caractérisé en ce qu'une rainure longitudinale est ménagée sur tout le pourtour de l'enceinte (2) constituée des parois latérales (3,4,5,6).

## Patentansprüche

1. Gehäuse für elektronische Bauteile, insbesondere hybride Bauteile, welches einen Boden (1), eine von Seitenwänden (3,4,5,6) gebildete Einfassung (2) und einen Deckel (7) umfaßt, der geeignet ist, das Gehäuse hermetisch abzuschließen, indem er sich auf ein oberes Ende der Seitenwände abstützt,
**dadurch gekennzeichnet,** daß mindestens eine Seitenwand, die zum Verbinden des Gehäuseinneren mit der Außenseite Durchlaßöffnungen (8) für Verbindungsstücke (9) umfaßt, in einen oberen Teil (11), zwischen den Öffnungen (8) und dem oberen Ende mindestens eine Längsrinne (12) umfaßt.

2. Gehäuse nach Anspruch 1, dadurch gekennzeichnet, daß die Rinne (12) zur Außenseite des Gehäuses hin geöffnet ist.

3. Gehäuse nach Anspruch 1, dadurch gekennzeichnet, daß die Rinne (12) zur Innenseite des Gehäuses hin geöffnet ist.

4. Gehäuse nach einem der Ansprüche 1 bis 3, dadurch gekennzeichnet, daß jede seiner Seitenwände (3,4,5,6), die Durchlaßöffnungen (8) für Verbindungsstücke umfaßt, wenigstens eine Längsrinne (12) umfaßt.

5. Gehäuse nach einem der Ansprüche 1 bis 4, dadurch gekennzeichnet, daß die Abmessungen von Tiefe und Höhe der Rinne (12) in Abhängigkeit von den Verformungen bemessen sind, die der obere Teil (11) bei Druck auf den Deckel absorbieren muß.

6. Gehäuse nach einem der Ansprüche 1 bis 5, dadurch gekennzeichnet, daß die Seitenwand zwei parallele Längsrinnen (14) umfaßt.

7. Gehäuse nach einem der Ansprüche 1 bis 6, dadurch gekennzeichnet, daß die Seitenwände zu beiden Seiten der Durchlaßöffnungen (8) mindestens eine Längsrinne umfassen.

8. Gehäuse nach einem der Ansprüche 1 bis 7, dadurch gekennzeichnet, daß eine Längsrinne um die ganze von den Seitenwänden (3,4,5,6) gebildete Einfassung (2) herum ausgespart ist.

## Claims

1. A package for electronic components and especially hybrid components comprising a base (1), an enclosure (2) formed by lateral walls (3,4,5,6) and a lid (7) having the function of hermetically sealing the package while bearing on a top end of the lateral walls, wherein at least one lateral wall having through-holes (8) for connecting-leads (9) which serve to establish a connection between the interior of the package and the exterior is provided with at least one longitudinal groove (12) in an upper portion (11) located between said through-holes (8) and the top end of the wall.

2. A package according to claim 1, wherein said groove (12) is open towards the exterior of the package.

3. A package according to claim 1, wherein said groove (12) is open towards the interior of the package.

4. A package according to any one of the claims 1 to 3, wherein each lateral package wall (3,4,5,6) which has through-holes (8) for connecting-leads is provided with at least one longitudinal groove (12).

5. A package according to any one of the claims 1 to 4, wherein the dimensions of said groove (12) in depth and in height are determined according to the deformations to be absorbed by the upper portion (11) of the lateral package walls by reason of the pressures on the lid.

6. A package according to any one of the claims 1 to 5, wherein the lateral wall has two parallel longitudinal grooves (14).

7. A package according to any one of the claims 1 to 6, wherein each lateral wall is provided with at least one longitudinal groove on each side of the through-holes (8).

8. A package according to any one of the claims 1 to 7, wherein a longitudinal groove is formed over the entire periphery of the enclosure (2) constituted by the lateral walls (3,4,5,6).
